# EUROPEAN PATENT APPLICATION

(11) **EP 4 658 016 A1**
(43) Date of publication of application: **03.12.2025**
(21) Application number: 25162552.1
(22) Date of filing: 10.03.2025
(51) Int. Cl.: H10B 51/20, H10D 30/01, H10D 64/01

(54) **SEMICONDUCTOR MEMORY DEVICE AND ELECTRONIC SYSTEM INCLUDING THE SAME**

(30) Priority: 31.05.2024 KR 20240072041
(71) Applicant: Samsung Electronics Co., Ltd., Suwon-si, Gyeonggi-do 16677 (KR)
(72) Inventor: LIM, Junyeong, 16677 Suwon-si (KR); MYEONG, Ilho, 16677 Suwon-si (KR); LIM, Suhwan, 16677 Suwon-si (KR); HONG, Sungduk, 16677 Suwon-si (KR)
(74) Representative: Marks & Clerk LLP

(57) **Abstract**

An example semiconductor memory device includes a cell substrate (100), a mold structure (MS), and a channel structure (CH1). The cell substrate includes a first side (100a) and a second side (100b) opposite to the first side. The mold structure includes a plurality of gate electrodes (124) and a plurality of mold insulating films (110) alternately stacked on the first side of the cell substrate. The channel structure extends through the mold structure and includes a ferroelectric layer (132), a channel layer (134), and a back gate electrode (138) stacked in turn on a side surface of the plurality of gate electrodes. The plurality of gate electrodes and the channel structure may define a plurality of memory cells, and during a read operation of a select memory cell of the plurality of memory cells, a back gate voltage may be applied to the back gate electrode of the channel structure.

## Description

### BACKGROUND

Certain electronic systems are desired to include a semiconductor memory device capable of storing high-capacity data. Accordingly, ways to increase the data storage capacity of semiconductor memory devices are being studied. For example, as a way to increase the data storage capacity of the semiconductor device, a semiconductor memory device has been proposed that includes three-dimensional arrangement of memory cells instead of two-dimensional arrangement of memory cells.

When performing a read operation in the semiconductor memory device, high voltage is applied to the target cell and other cells for channel formation, which may degrade the reliability of the memory cell. This may cause performance degradation and damage to the semiconductor memory device.

### SUMMARY

In order to solve one or more problems (e.g., the problems described above and/or other problems not explicitly described herein), the present disclosure provides a semiconductor memory device and an electronic system including the same.

In some implementations, a semiconductor memory device may include a cell substrate including a first side and a second side opposite to the first side, a mold structure including a plurality of gate electrodes and a plurality of mold insulating films alternately stacked on the first side of the cell substrate, and a channel structure extending through the mold structure and including a ferroelectric layer, a channel layer, and a back gate electrode stacked in turn on a side surface of the plurality of gate electrodes, in which the plurality of gate electrodes and the channel structure may form a plurality of memory cells, and during a read operation of a select memory cell of the plurality of memory cells, a back gate voltage may be applied to the back gate electrode of the channel structure.

The back gate electrode may be configured to receive the back gate voltage during the read operation and apply the back gate voltage to the channel layer. The back gate voltage may be applied to a side of the channel layer that faces the back gate electrode.

The semiconductor memory device may comprise peripheral circuitry (e.g. a peripheral circuit) configured to apply the back gate voltage to the back gate electrode of the channel structure during a read operation of a select memory cell of the plurality of memory cells.

The plurality of gate electrodes may include a plurality of word lines. The semiconductor memory device may comprise peripheral circuitry (e.g. a peripheral circuit) configured to apply an unselect voltage to an unselect word line of the plurality of word lines during the read operation of the select memory cell, the unselect word line being associated with an unselect memory cell of the plurality of memory cells.

The plurality of gate electrodes may include a plurality of word lines. The semiconductor memory device may comprise peripheral circuitry (e.g. a peripheral circuit) configured to apply a select voltage to a select word line of a plurality of word lines during the read operation of the select memory cell, the select word line being associated with the select memory cell.

The semiconductor memory device may comprise peripheral circuitry (e.g. a peripheral circuit) configured to apply a bit line voltage to a bit line that is electrically connected to the channel layer during a read operation of the select memory cell.

A voltage generation circuit may be provided for generating voltages used by the semiconductor memory device (e.g. a back gate voltage, a bit line voltage, an unselect word line voltage and/or a select word line voltage).

In some implementations, a semiconductor memory device may include a cell substrate including a first side and a second side opposite to the first side, a mold structure including a plurality of gate electrodes and a plurality of mold insulating films alternately stacked on the first side of the cell substrate, and a channel structure extending through the mold structure and including a ferroelectric layer, a channel layer, and a back gate electrode stacked in turn on a side surface of the plurality of gate electrodes, in which the plurality of gate electrodes and the channel structure may form a plurality of memory cells, and further including peripheral circuitry configured to apply a back gate voltage to the back gate electrode of the channel structure during a read operation of a select memory cell of the plurality of memory cells.

In some implementations, a semiconductor memory device may include a cell substrate, a mold structure including a plurality of gate electrodes stacked on the cell substrate, and a channel structure extending through the mold structure, in which the channel structure may include a ferroelectric layer, a channel layer, and a back gate electrode, and a back gate voltage may be applied to the back gate electrode of the channel structure during a read operation.

In some implementations, an electronic system may include a main substrate, a semiconductor memory device on the main substrate, and a controller electrically connected to the semiconductor memory device on the main substrate, in which a semiconductor memory device may include a cell substrate, a mold structure including a plurality of gate electrodes and a plurality of mold insulating films alternately stacked on the cell substrate, and a channel structure extending through the mold structure and including a ferroelectric layer, a channel layer, and a back gate electrode stacked in turn on a side surface of the plurality of gate electrodes, in which the plurality of gate electrodes and the channel structure may form a plurality of memory cells, and during a read operation of a select memory cell of the plurality of memory cells, a back gate voltage may be applied to the back gate electrode of the channel structure.

In some implementations, the back gate voltage is applied to the back gate electrode in the read operation, and as a result, a low voltage may be applied to the unselect word line. As a result, a read disturb phenomenon can be alleviated, and it is possible to provide a semiconductor memory device with improved reliability.

At least some of the above and other features of the invention are set out in the claims. The effects of the present disclosure are not limited to the effects described above, and other effects not described herein can be clearly understood by those of ordinary skill in the art (referred to as "ordinary technician") from the description of the claims.

### BRIEF DESCRIPTION OF THE DRAWINGS

The above and other objects, features and advantages of the present disclosure will be described with reference to the accompanying drawings described below, where similar reference numerals indicate similar elements, but not limited thereto, in which:
FIG. 1 is a block diagram illustrating an example of a semiconductor memory device;
FIGS. 2, 3, and 4 are circuit diagrams illustrating some examples of the semiconductor memory device;
FIG. 5 is a schematic layout diagram illustrating an example of the semiconductor memory device;
FIG. 6 is an example cross-sectional view taken along line I-I of FIG. 5;
FIG. 7 is an enlarged view of an example of a first channel structure;
FIG. 8 is an enlarged view of an example of a portion A of FIG. 6;
FIG. 9 is an enlarged view of an example of the first channel structure;
FIG. 10 is an enlarged view of an example of the portion A of FIG. 6;
FIG. 11 is an enlarged view of an example of the first channel structure;
FIG. 12 is an enlarged view of an example of the portion A of FIG. 6;
FIG. 13 is a diagram illustrating an example of a bias condition of a select bit line;
FIG. 14 is a diagram illustrating an example of the portion A of FIG. 6 during a read operation;
FIGS. 15, 16, and 17 are cross-sectional views illustrating examples of the semiconductor memory device;
FIGS. 18 and 19 are cross-sectional views illustrating examples of the semiconductor memory device;
FIG. 20 is a block diagram illustrating an example of an electronic system;
FIG. 21 is a perspective view illustrating an example of the electronic system; and
FIG. 22 is an example cross-sectional view taken along line I-I of FIG. 21.

### DETAILED DESCRIPTION

Hereinafter, example details for the practice of the present disclosure will be described in detail with reference to the accompanying drawings. However, in the following description, detailed descriptions of well-known functions or configurations will be omitted if it may make the subject matter of the present disclosure rather unclear.

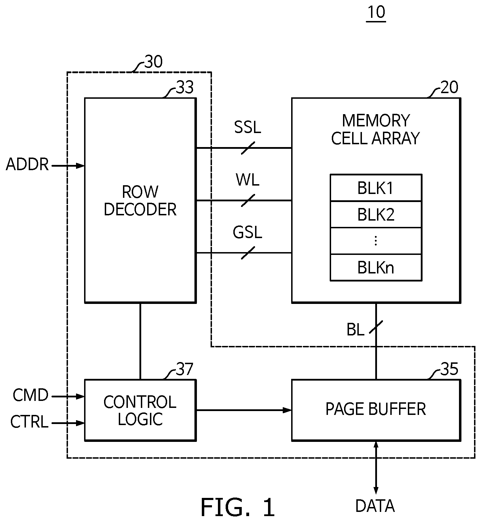

FIG. 1 is a block diagram illustrating an example of a semiconductor memory device 10. Referring to FIG. 1, the semiconductor memory device 10 may include a memory cell array 20 and a peripheral circuit 30.

The memory cell array 20 may include a plurality of memory cell blocks BLK1 to BLKn. Each of the memory cell blocks BLK1 to BLKn may include a plurality of memory cells. The memory cell array 20 may be connected to the peripheral circuit 30 through bit lines BL, word lines WL, at least one string select line SSL, and at least one ground select line GSL. Specifically, the memory cell blocks BLK1 to BLKn may be connected to a row decoder 33 through the word lines WL, the string select line SSL, and the ground select line GSL. In addition, the memory cell blocks BLK1 to BLKn may be connected to a page buffer 35 through the bit lines BL.

The peripheral circuit 30 may receive an address ADDR, a command CMD, and a control signal CTRL from the outside of the semiconductor memory device 10 (e.g. from an external device), and may transmit and receive data DATA to and from an external device outside the semiconductor memory device 10. The peripheral circuit 30 may include a control logic 37, the row decoder 33, and the page buffer 35. Although not illustrated, the peripheral circuit 30 may further include various sub-circuits such as an input and output circuit, a voltage generation circuit that generates various voltages necessary for the operation of the semiconductor memory device 10, and/or an error correction circuit for correcting an error of the data DATA read from the memory cell array 20.

The control logic 37 may be connected to the row decoder 33, the input and output circuit, and the voltage generation circuit. The control logic 37 may control the overall operation of the semiconductor memory device 10. In response to the control signal CTRL, the control logic 37 may generate various internal control signals for use in the semiconductor memory device 10. For example, when performing a memory operation such as read operation, program operation, or erase operation, the control logic 37 may adjust the voltage level provided to the word lines WL and the bit lines BL.

In response to the address ADDR, the row decoder 33 may select at least one of the plurality of memory cell blocks BLK1 to BLKn, and may select at least one word line WL, at least one string select line SSL, and at least one ground select line GSL of the selected memory cell block BLK1 to BLKn. In addition, the row decoder 33 may transmit a voltage for performing the memory operation to the word line WL of the selected memory cell block BLK1 to BLKn.

The page buffer 35 may be connected to the memory cell array 20 through the bit lines BL. The page buffer 35 may operate as a write driver or a sense amplifier. Specifically, when performing a program operation, the page buffer 35 may operate as the write driver and apply a voltage according to the data DATA to be stored in the memory cell array 20 to the bit line BL. On the other hand, when performing a read operation, the page buffer 35 may operate as a sense amplifier and sense the data DATA stored in the memory cell array 20. For instance, when performing a read operation, the page buffer 35 may be configured to apply respective bit line voltages to one or more of the bit lines (e.g. depending on whether the bit lines are selected or unselected), and to sense a read current passing through a selected memory cell.

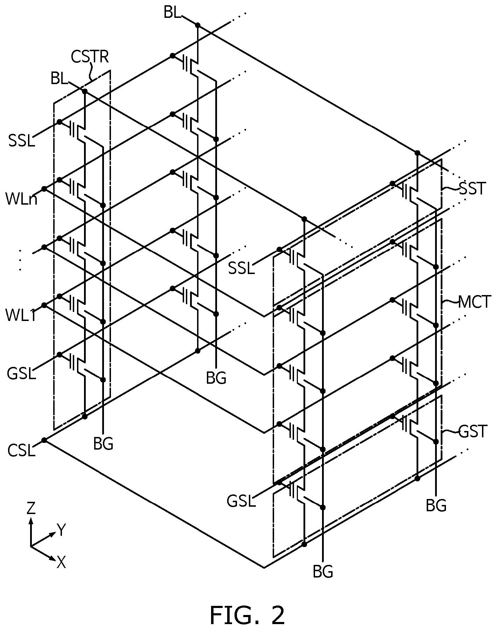

FIGS. 2, 3, and 4 are circuit diagrams illustrating examples of the semiconductor memory device. Referring to FIG. 2, the memory cell array (e.g., 20 in FIG. 1) of the semiconductor memory device may include a common source line CSL, a plurality of bit lines BL, and a plurality of cell strings CSTR.

A plurality of bit lines BL may be arranged two-dimensionally in a plane including a first direction X and a second direction Y (e.g. a horizontal plane). For example, each of the plurality of bit lines BL may extend in the first direction X, and may be spaced apart from each other and arranged along the second direction Y. The plurality of cell strings CSTR may be connected in parallel to each of the bit lines BL. The plurality of cell strings CSTR may be coupled in common to the common source line CSL. That is, the plurality of cell strings CSTR may be disposed between the bit lines BL and the common source line CSL.

Referring to FIGS. 2 to 4, each of the cell strings CSTR may include a ground select transistor GST connected to the common source line CSL, a string select transistor SST connected to the bit line BL, and a plurality of memory cell transistors MCT arranged between the ground select transistor GST and the string select transistor SST. Each of the memory cell transistors MCT may include a data storage element. The ground select transistor GST, the string select transistor SST, and the memory cell transistors MCT may be connected to each other in series.

The common source line CSL may be connected in common to sources of the ground select transistors GST. In addition, the ground select line GSL, a plurality of word lines WL1 to WLn, and a string select line SSL may be disposed between the common source line CSL and the bit line BL. The ground select line GSL may be used as a gate electrode of the ground select transistor GST, the word lines WL1 to WLn may be used as gate electrodes of the memory cell transistors MCT, and the string select line SSL may be used as a gate electrode of the string select transistor SST.

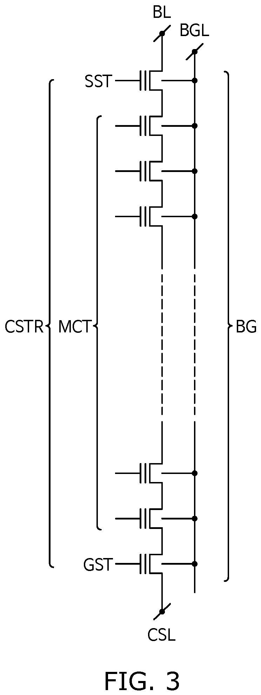

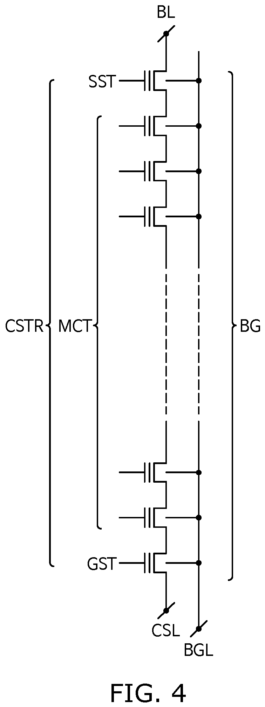

The memory cell array may further include a back gate electrode BG for a back bias. One end of the back gate electrode BG may be connected to a back gate line BGL. For example, as illustrated in FIG. 3, the back gate electrode BG may be connected to a back gate line BGL positioned above the cell string CSTR. As another example, as illustrated in FIG. 4, the back gate electrode BG may be connected to a back gate line BGL positioned below the cell string CSTR. The other end of the back gate electrode BG may be floated.

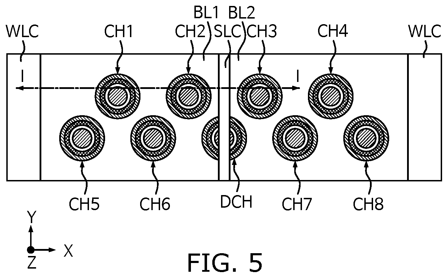

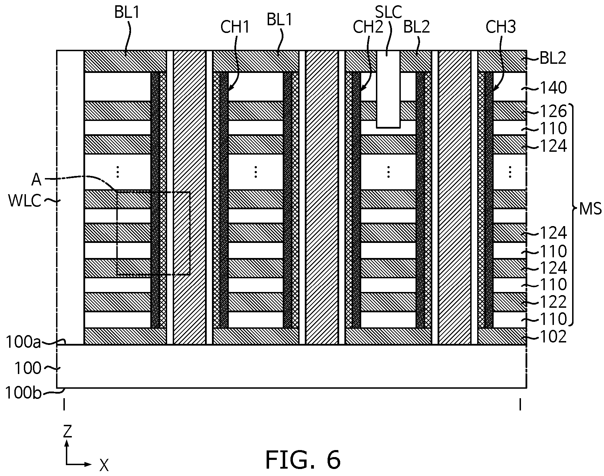

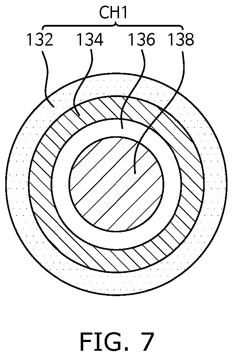

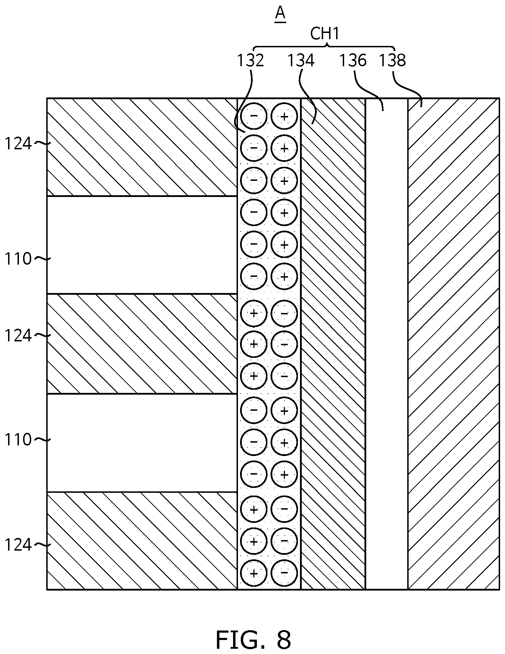

FIG. 5 is a schematic layout diagram illustrating an example of the semiconductor memory device. FIG. 6 is an example cross-sectional view taken along line I-I of FIG. 5. FIG. 7 is an enlarged view of an example of a first channel structure CH1. FIG. 8 is an enlarged view of an example of a portion A of FIG. 6. In FIG. 5, the bit lines BL1 and BL2 are shown without cross-hatching.

Referring to FIGS. 5 and 6, the semiconductor memory device may include a cell substrate 100, a source layer 102, a mold structure MS, an interlayer insulating layer 140, the bit lines BL1 and BL2, a word line cutting structure WLC, a string line cutting structure SLC, the channel structures CH1 to CH8, and a dummy channel structure DCH.

The cell substrate 100 may include a first side 100a and a second side 100b opposite to each other. The first side 100a of the cell substrate 100 and the second side 100b of the cell substrate 100 may be opposite to each other in a third direction Z (e.g. a vertical direction). The third direction Z may intersect (e.g. may be perpendicular to) the first direction X and the second direction Y. The first direction X and the second direction Y may be parallel to the first side 100a of the cell substrate 100 and may intersect each other (e.g., may be perpendicular to each other). The third direction Z may be perpendicular to the first side 100a of the cell substrate 100. The third direction Z may define a height direction of the semiconductor memory device. A feature that is described as "above" another feature, may be located further along the third direction Z than the other feature. An upper portion of a feature may be above a lower portion of the feature. It will be appreciated that these directions or positions are defined relative to the structure of the semiconductor memory device and need not imply any particular orientation of the semiconductor memory device in use.

For example, the cell substrate 100 may include a semiconductor substrate such as a silicon substrate, a germanium substrate, or a silicon-germanium substrate. Alternatively, the cell substrate 100 may include a silicon-on-insulator (SOI) substrate or a germanium-on-insulator (GOI) substrate, etc. The cell substrate 100 may include an impurity. For example, the cell substrate 100 may include n-type impurities (e.g., phosphorus (P), arsenic (As), etc.). As another example, the cell substrate 100 may include p-type impurities (e.g., boron (B), aluminum (Al), gallium (Ga), etc.).

The source layer 102 may be disposed on the first side 100a of the cell substrate 100. The source layer 102 may be provided as the common source line (CSL of FIG. 2) of the semiconductor memory device. The source layer 102 may include a conductive material, for example, polysilicon or metal doped with impurities, but is not limited thereto.

The mold structure MS may be disposed on the first side 100a of the cell substrate 100. The mold structure MS may be disposed on the source layer 102. That is, the source layer 102 may be interposed between the cell substrate 100 and the mold structure MS.

The mold structure MS may include a plurality of gate electrodes 122, 124, and 126 and a plurality of mold insulating films 110 stacked on the cell substrate 100. Each of the gate electrodes 122, 124, and 126 and each of the mold insulating films 110 may have a layered structure extending parallel to the first side 100a of the cell substrate 100. The gate electrodes 122, 124, and 126 may be spaced apart from each other by the mold insulating films 110 and stacked in turn on the cell substrate 100. That is, the gate electrodes 122, 124, and 126 and the mold insulating film 110 may be alternately stacked on the cell substrate 100. The mold structure MS may be otherwise known as a cell structure or a stack structure. The mold insulating films 110 may be otherwise known as insulating films.

The plurality of gate electrodes 122, 124, and 126 may be stacked in a stepwise manner. For example, the plurality of gate electrodes 122, 124, and 126 may extend to different lengths in the first direction X to form steps. The plurality of gate electrodes 122, 124, and 126 may have steps in the second direction Y. Accordingly, each of the gate electrodes 122, 124, and 126 may include an exposed region exposed from another gate electrode. The exposed region may refer to a region where a cell contact is in contact with the gate electrodes 122, 124, and 126.

The plurality of gate electrodes 122, 124, and 126 may include at least one ground select line 122, a plurality of word lines 124, and at least one string select line 126 stacked in turn on the cell substrate 100. The number and arrangement, etc. of the mold insulating films 110 and the gate electrodes 122, 124, and 126 are merely illustrative, and are not limited to those illustrated in the drawings.

Each of the gate electrodes 122, 124, and 126 may include a conductive material, for example, a metal such as tungsten (W), molybdenum (Mo), ruthenium (Ru), cobalt (Co), nickel (Ni), or a semiconductor material such as silicon, but is not limited thereto. For example, each of the gate electrodes 122, 124, and 126 may include at least one of tungsten (W), molybdenum (Mo), and ruthenium (Ru). As another example, each of the gate electrodes 122, 124, and 126 may include polysilicon. Unlike the illustration, the gate electrodes 122, 124, and 126 may be multi-layered. For example, if the gate electrodes 122, 124, and 126 are multi-layered, the gate electrodes 122, 124, and 126 may include a gate electrode barrier film and a gate electrode filling film. For example, the gate electrode barrier layer may include titanium nitride (TiN), and the gate electrode filling layer may include tungsten (W), but is not limited thereto.

For example, the mold insulating film 110 may include at least one of silicon oxide, silicon nitride, and silicon oxynitride, but is not limited thereto. For example, the mold insulating film 110 may include a silicon oxide layer.

The interlayer insulating layer 140 may be disposed on the first side 100a of the cell substrate 100. The interlayer insulating layer 140 may cover the mold structure MS. For example, the interlayer insulating layer 140 may include at least one of silicon oxide, silicon oxynitride, and a low-k material having a lower dielectric constant than silicon oxide, but is not limited thereto.

The bit lines BL1 and BL2 may be disposed on the mold structure MS. The bit lines BL1 and BL2 may be disposed on the interlayer insulating layer 140. The bit lines BL1 and BL2 may be electrically connected to the channel structures CH1 to CH8.

The word line cutting structure WLC may cut the bit lines BL1 and BL2, the interlayer insulating layer 140, and the mold structure MS. The mold structure MS may be divided by the word line cutting structure WLC to form a plurality of memory cell blocks (e.g., BLK1 to BLKn of FIG. 1). A plurality of word line cutting structures WLC may be arranged two-dimensionally in a plane including the first direction X and the second direction Y. For example, the word line cutting structures WLC may be spaced apart from each other and arranged along the first direction X, and may each extend in the second direction Y.

The word line cutting structure WLC may include an insulating material, for example, at least one of silicon oxide, silicon nitride, and silicon oxynitride, but is not limited thereto.

The string line cutting structure SLC may be disposed between the word line cutting structures WLC. The string line cutting structure SLC may cut the bit lines BL1 and BL2, the interlayer insulating layer 140, and the mold structure MS. The string line cutting structure SLC may overlap the dummy channel structure DCH in the third direction Z.

The string line cutting structure SLC may include an insulating material, for example, at least one of silicon oxide, silicon nitride, and silicon oxynitride, but is not limited thereto.

The plurality of channel structures CH1 to CH8 and the dummy channel structure DCH may be arranged in a zigzag form. For example, the plurality of channel structures CH1 to CH8 and the dummy channel structure DCH may be arranged such that they are staggered from each other in the first direction X and the second direction Y. For example, the first to eighth channel structures CH1 to CH8 and the dummy channel structures DCH may be arranged in the zigzag form between neighboring word line cutting structures WLC. The first to fourth channel structures CH1 to CH4 may be arranged along the first direction X, and the fifth and sixth channel structures CH5 and CH6, the dummy channel structure DCH, and the seventh and eighth channel structures CH7 and CH8 may be arranged along the first direction X.

The number and arrangement, etc. of the plurality of channel structures CH1 to CH8 and the dummy channel structure DCH are merely illustrative, and are not limited thereto. In another aspect, the plurality of channel structures CH1 to CH8 may be arranged in a honeycomb form.

The bit lines BL1 and BL2 may be separated by the string cutting line structure SLC. The channel structures CH1 to CH8 disposed between the word line cutting structure WLC and the string line cutting structure SLC may share the bit lines BL1 and BL2. For example, the first, second, fifth, and sixth channel structures CH1, CH2, CH5, and CH6 may be connected in common to the bit line BL1. In addition, the third, fourth, seventh, and eighth channel structures CH3, CH4, CH7, and CH8 may be connected in common to the bit line BL2.

The plurality of channel structures CH1 to CH8 may be disposed on the first side 100a of the cell substrate 100. The channel structures CH1 to CH8 may extend through the mold structure MS in a vertical direction (hereinafter, referred to as a third direction Z) intersecting the upper surface of the cell substrate 100. For example, the channel structures CH1 to CH8 may be pillar-shaped (e.g., cylindrical) extending in the third direction Z. Accordingly, the channel structures CH1 to CH8 may intersect the gate electrodes 122, 124, and 126. Each of the channel structures CH1 to CH8 and the dummy channel structure DCH may have the same or similar structure. Therefore, the structures of the channel structures CH1 to CH8 and the dummy channel structures DCH will be described below with reference to the first channel structure CH1 as an example. In the following description, upper and lower surfaces, upper and lower portions, and upper and lower sides may be divided based on the third direction Z.

Referring to FIGS. 6 to 8, the first channel structure CH1 may include a ferroelectric layer 132, a channel layer 134, a first insulating layer 136, and a back gate electrode 138 that are stacked in turn on side surfaces or sidewalls of the gate electrodes 122, 124, and 126. For example, a channel hole may be formed, extending in the third direction Z through the mold structure MS. The ferroelectric layer 132, the channel layer 134, the first insulating layer 136, and the back gate electrode 138 may be stacked in turn in the channel hole.

The back gate electrode 138 may extend on the first side 100a of the cell substrate 100 in the third direction Z. The back gate electrode 138 may extend through the mold structure MS.

For example, the back gate electrode 138 may have a pillar shape. For example, the back gate electrode 138 may include a metal such as tungsten (W), copper (Cu), aluminum (Al), titanium (Ti), tantalum (Ta), ruthenium (Ru), and gold (Au), but is not limited thereto.

The first insulating layer 136 may be disposed on a side surface or a sidewall of the back gate electrode 138. The first insulating layer 136 may extend along at least a portion of the sidewall of the back gate electrode 138. The first insulating layer 136 may surround at least a portion of the back gate electrode 138. The first insulating layer 136 may be disposed between the mold structure MS and the back gate electrode 138. The first insulating layer 136 may have a shape of a hollow barrel, for example, a cylindrical shape, but is not limited thereto.

For example, the first insulating layer 136 may include at least one of silicon oxide, silicon nitride, and silicon oxynitride, but is not limited thereto.

The channel layer 134 may be disposed on the side surface or the sidewall of the first insulating layer 136. The channel layer 134 may extend along at least a portion of an outer wall of the first insulating layer 136. The channel layer 134 may surround at least a portion of the first insulating layer 136. The channel layer 134 may be disposed between the mold structure MS and the first insulating layer 136. The channel layer 134 may extend in the third direction Z and intersect the gate electrodes 122, 124, and 126. For example, the channel layer 134 may have a cylindrical shape, but is not limited thereto.

One end of the channel layer 134 may be electrically connected to the source layer 102. For example, the lower surface of the channel layer 134 in the third direction Z may be in contact with the source layer 102. Although FIG. 6 illustrates that the lower surface of the channel layer 134 is disposed on the same plane as the upper surface of the source layer 102, this is merely an example, and aspects are not limited thereto. As another example, a lower portion of the channel layer 134 may be buried in the source layer 102 such that the lower surface of the channel layer 134 may be disposed below the upper surface of the source layer 102.

The other end of the channel layer 134 may be electrically connected to the first bit line BL1. For example, an upper surface of the channel layer 134 may be in contact with the first bit line BL1. Although FIG. 6 illustrates that the upper surface of the channel layer 134 is disposed on the same plane as the lower surface of the first bit line BL1, this is merely an example, and aspects are not limited thereto. As another example, an upper portion of the channel layer 134 may be buried in the first bit line BL1 such that the upper surface of the channel layer 134 may be disposed above the lower surface of the first bit line BL1. Likewise, the other end of the channel layer of the third channel structure CH3 may be electrically connected to the second bit line BL2. For example, the upper surface of the channel layer of the third channel structure CH3 may be in contact with the second bit line BL2.

For example, the channel layer 134 may include a semiconductor material such as single crystal silicon, polycrystalline silicon, an organic semiconductor material, and a carbon nanostructure, but is not limited thereto.

The ferroelectric layer 132 may be disposed on the side surface or the sidewall of the channel layer 134. The ferroelectric layer 132 may extend along at least a portion of an outer wall of the channel layer 134. The ferroelectric layer 132 may surround at least a portion of the channel layer 134. The ferroelectric layer 132 may be disposed between the mold structure MS and the channel layer 134. For example, the ferroelectric layer 132 may have a cylindrical shape, but is not limited thereto.

The ferroelectric layer 132 may include one or more ferroelectrics (e.g. may include one or more ferroelectric materials). The ferroelectrics may refer to materials that have spontaneous polarization and change polarized state by an external electric field. The polarized state of the ferroelectric layer 132 may be maintained even when the power of the semiconductor memory device is turned off. That is, the semiconductor memory device including the ferroelectric layer 132 may serve as a non-volatile memory device.

For example, the ferroelectric layer 132 may include at least one of hafnium oxide, zirconium oxide, yttrium-doped zirconium oxide, yttrium-doped zirconium oxide, magnesium-doped zirconium oxide, magnesium-doped hafnium oxide, silicon-doped hafnium oxide, silicon-doped zirconium oxide, barium-doped titanium oxide, and a combination thereof, but is not limited thereto.

The semiconductor memory device may store information using changing polarized states of the ferroelectric layer 132 that includes the ferroelectrics. The first through eighth channel structures CH1 to CH8, each including the ferroelectric layer 132, may form the word line 124 and the memory cell.

By changing the polarized state of the ferroelectric layer 132, information may be stored in the memory cell. That is, by changing the polarized state of the ferroelectric layer 132, a program operation and/or an erase operation may be performed. For example, the program operation may be performed such that positive charges are placed in a region facing the channel layer 134 of at least a partial region of the ferroelectric layer 132 associated with a memory cell to program. As another example, the erase operation may be performed such that negative charges are placed in a region facing the channel layer 134 of at least a partial region of the ferroelectric layer 132 associated with a memory cell to erase.

A threshold voltage of the memory cell may vary depending on the polarized state of the ferroelectric layer 132. Threshold voltage may refer to the minimum gate to source voltage required to create a conducting path through a memory cell (e.g. through the transistor forming the memory cell). Additionally or alternatively, the magnitude of the current flowing through the channel layer when a specific voltage greater than the threshold voltage is applied to the word line 124 may vary depending on the polarized state of the ferroelectric layer 132. Using these characteristics, the information stored in the memory cell may be read during read operation.

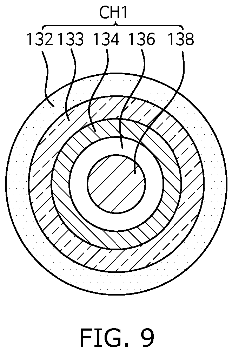

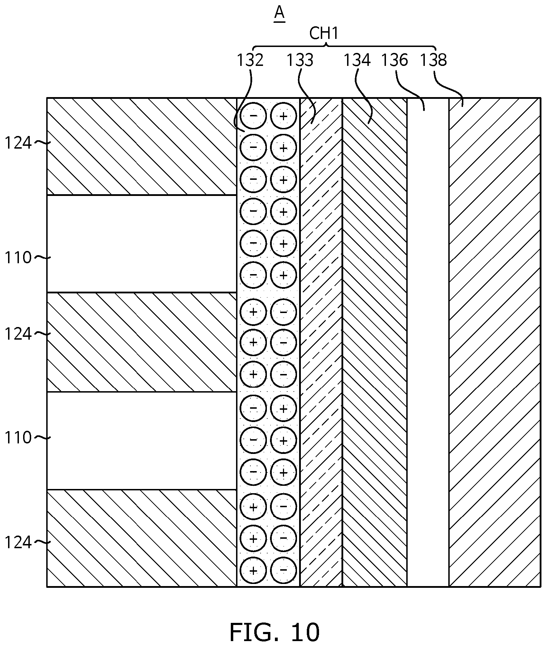

FIG. 9 is an enlarged view of an example of the first channel structure CH1. FIG. 10 is an enlarged view of an example of the portion A of FIG. 6. In the following description of FIGS. 9 and 10, description of the components or operations already described above with reference to FIGS. 1 to 8 will be omitted, and differences will be mainly described below with reference to FIGS. 9 and 10.

Referring to FIGS. 9 and 10, the first channel structure CH1 may include the ferroelectric layer 132, a second insulating layer 133, the channel layer 134, the first insulating layer 136, and the back gate electrode 138 that are stacked in turn on the side surface or sidewall of the gate electrode 122, 124, and 126 of FIG. 6. The ferroelectric layer 132, the second insulating layer 133, the channel layer 134, the first insulating layer 136, and the back gate electrode 138 may be stacked in turn in the channel hole. That is, compared to the first channel structure CH1 illustrated in FIGS. 7 and 8, the first channel structure CH1 illustrated in FIGS. 9 and 10 has a difference that it may further include the second insulating layer 133.

The second insulating layer 133 may be disposed on the outer wall of the channel layer 134. The second insulating layer 133 may extend along at least a portion of the outer wall of the channel layer 134. The second insulating layer 133 may surround at least a portion of the channel layer 134. The second insulating layer 133 may be disposed between the channel layer 134 and the ferroelectric layer 132. The second insulating layer 133 may have a shape of a hollow barrel, for example, a cylindrical shape, but is not limited thereto.

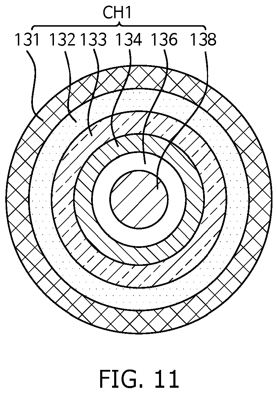

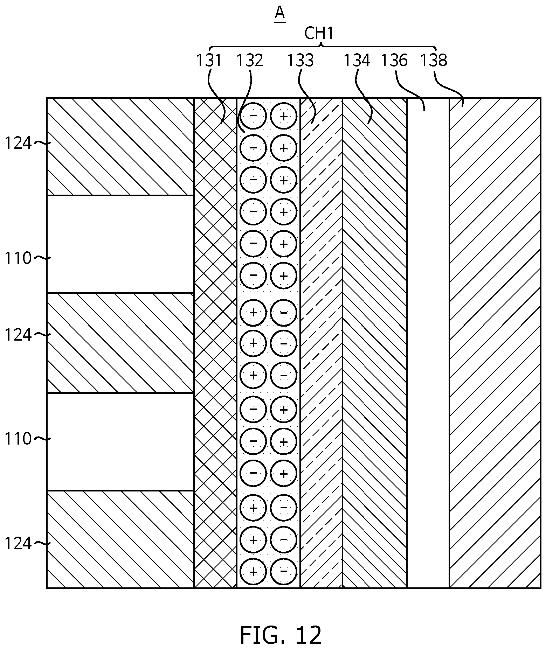

FIG. 11 is an enlarged view of an example of the first channel structure CH1. FIG. 12 is an enlarged view of an example of the portion A of FIG. 6. In the following description of FIGS. 11 and 12, description of the components or operations already described above with reference to FIGS. 1 to 10 will be omitted, and differences will be mainly described below with reference to FIGS. 11 and 12.

Referring to FIGS. 11 and 12, the first channel structure CH1 may include a third insulating layer 131, the ferroelectric layer 132, the second insulating layer 133, the channel layer 134, the first insulating layer 136, and the back gate electrode 138 that are stacked in turn on the side surface or sidewall of the gate electrode 122, 124, and 126 of FIG. 6. The third insulating layer 131, the ferroelectric layer 132, the second insulating layer 133, the channel layer 134, the first insulating layer 136, and the back gate electrode 138 may be stacked in turn in the channel hole. That is, compared to the first channel structure CH1 illustrated in FIGS. 9 and 10, the first channel structure CH1 illustrated in FIGS. 11 and 12 has a difference that it may further include the third insulating layer 131.

The third insulating layer 131 may be disposed on the side surface or the sidewall of the ferroelectric layer 132. The third insulating layer 131 may extend along at least a portion of the outer wall of the ferroelectric layer 132. The third insulating layer 131 may surround at least a portion of the ferroelectric layer 132. The third insulating layer 131 may be disposed between the mold structure MS of FIG. 6 and the ferroelectric layer 132. The third insulating layer 131 may have a shape of a hollow barrel, for example, a cylindrical shape, but is not limited thereto.

Hereinafter, for convenience of explanation, it is assumed that the channel structure has a structure including the ferroelectric layer 132, the channel layer 134, the first insulating layer 136, and the back gate electrode 138 (e.g. the structure of the example of FIGS. 7 and 8), but the scope of the present disclosure is not limited thereto, and the channel structure of various structures described above may be applicable to the present disclosure.

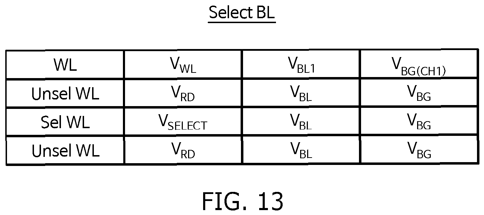

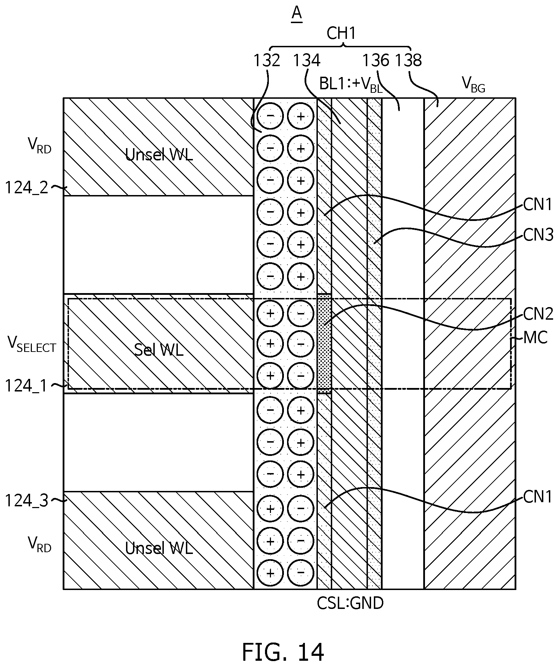

FIGS. 13 and 14 are diagrams provided to explain the read operation. FIG. 13 is a diagram illustrating an example of a bias condition of the select bit line. FIG. 14 is a diagram illustrating an example of the portion A of FIG. 6 during read operation.

Referring to FIGS. 13 and 14, the first channel structure CH1 including the select memory cell MC (e.g. a selected memory cell MC) that is a memory cell to read may be connected to the select bit line BL1. A select word line 124_1 (e.g. a selected word line 124_1) and the first channel structure CH1 may form the select memory cell MC that is the memory cell to read. Specifically, the select word line 124_1 and a partial region of the first channel structure CH1 associated with the select word line 124_1 (e.g., a partial region of the first channel structure CH1 on a side surface or sidewall of the select word line 124_1) may form the select memory cell MC. Likewise, unselect (e.g. unselected) word lines 124_2 and 124_3 and the first channel structure CH1 may form unselect (e.g. unselected) memory cells that are not memory cells to read (e.g. memory cells that are not to be read). Specifically, the unselect word lines 124_2 and 124_3 and a partial region of the first channel structure CH1 associated with the unselect word lines 124_2 and 124_3 (e.g., a partial region of the sidewalls of the unselect word lines 124_2 and 124_3 of the first channel structure CH1) may form the unselect memory cells. The select and unselect memory cells may be defined based on a read command (e.g. an address of a read command). The control logic 37 may receive the read command and may control the semiconductor memory device (e.g. the row decoder 33) to provide respective voltages to the select and unselect word lines. Details of the particular voltages provided to the word lines are given below.

During the read operation for the select memory cell MC, an unselect voltage VRD may be applied to the unselect word lines 124_2 and 124_3. The unselect voltage VRD applied to the unselect word lines 124_2 and 124_3 may be greater than or equal to a threshold voltage associated with a plurality of memory cells included in the semiconductor memory device. For example, the unselect voltage VRD may be greater than or equal to a threshold voltage of a memory cell having the largest threshold voltage of the plurality of memory cells included in the semiconductor memory device. Accordingly, regardless of the polarized state of the ferroelectric layer 132 of the unselect memory cell, a channel CN1 may be formed in a region of the channel layer 134 facing the unselect word lines 124_2 and 124_3. The higher the unselect voltage VRD applied to the unselect word lines 124_2 and 124_3, the better the channel CN1 may be formed, and the thicker the channel CN1 may be (thereby increasing the current passing through the channel).

A select voltage VSELECT may be applied to the select word line 124_1 during the read operation for the select memory cell MC. The select voltage VSELECT applied to the select word line 124_1 may include a voltage between the highest and lowest threshold voltages of threshold voltages associated with the plurality of memory cells included in the semiconductor memory device.

A specific voltage between the highest threshold voltage and the lowest threshold voltage may be applied as the select voltage VSELECT to the select word line 124_1. Whether a channel CN2 is formed in a region of the channel layer 134 facing the select word line 124_1, or the thickness of the formed channel CN2, may vary according to the polarized state of the ferroelectric layer 132 of the select memory cell MC.

Additionally or alternatively, a sweep voltage, which varies within a voltage range between the highest threshold voltage and the lowest threshold voltage, may be applied as the select voltage VSELECT to the select word line 124_1. A voltage level (e.g. of the sweep voltage) at which the channel CN2 starts to form in a region of the channel layer 134 facing the select word line 124_1, that is, the threshold voltage of the select memory cell MC may vary according to the polarized state of the ferroelectric layer 132 of the select memory cell MC.

During the read operation for the select memory cell MC, a voltage may be applied to the common source line CSL and/or the select (e.g. selected) bit line BL1 such that a potential difference occurs between the common source line CSL and the select bit line BL1. For example, a ground voltage GND may be applied to the common source line CSL, and a bit line voltage +V_{BL} may be applied to the select bit line BL1. Conversely, unselect (e.g. unselected) bit lines may be set to a voltage such that there is no potential difference between the common source line CSL and the unselect bit lines (e.g. a ground voltage GND may be applied to both the unselect bit lines and the common source line). Again, the select and unselect bit lines may be defined based on a read command (e.g. an address of a read command). The control logic 37 may receive the read command and may control the semiconductor memory device (e.g. the page buffer 35) to provide respective voltages to the select and unselect bit lines.

If channels CN1 and CN2 are formed from the common source line CSL to the select bit line BL1 in the channel layer 134, that is, if the channel CN2 is formed in the region of the channel layer 134 facing the select word line 124_1, a read current may flow through the channels CN1 and CN2 due to the potential difference between the common source line CSL and the select bit line BL1. In this case, the magnitude of the read current may increase as the thickness of the formed channels CN1 and CN2 increases. The page buffer 35 may be configured to sense the read current during the read operation.

On the other hand, if the channels CN1 and CN2 connecting the common source line CSL to the select bit line BL1 are not formed in the channel layer 134, that is, if the channel CN2 is not formed in the region of the channel layer 134 facing the select word line 124_1, the read current may not flow through the channel layer 134.

The semiconductor memory device may read a polarized state of the ferroelectric layer 132 of the select memory cell MC, that is, may read information stored in the select memory cell MC based on whether the read current flows through the channel layer 134 and/or based on the magnitude of the read current.

If a high voltage is repeatedly applied to the word lines 124_1, 124_2, and 124_3 during the read operation, the information stored in the memory cell (i.e., the polarized state of the ferroelectric layer 132) may be slightly changed. That is, a read disturb phenomenon may occur. If the voltage applied to the unselect word lines 124_2 and 124_3 is lowered to alleviate the read disturb, the read current may decrease, and accordingly, it may be difficult to properly detect the information stored in the select memory cell MC. In particular, if the unselect word lines 124_2 and 124_3 have high threshold voltages, the read current may be significantly reduced upon decreasing the voltage applied to the unselect word lines 124_2 and 124_3.

A back gate voltage VBG may be applied to the back gate electrode 138 of the first channel structure CH1 during the read operation for the select memory cell MC. A channel CN3 may be formed in the channel layer 134 of the first channel structure CH1 by the back gate voltage VBG. Specifically, the channel CN3 may be formed by the back gate voltage VBG, in a region of the channel layer 134 facing the back gate electrode BG. That is, dual channels (a channel including CN1 and CN2, and a channel including CN3) may be formed in the channel layer 134. The channel CN3 formed by the back gate voltage VBG may allow the read current to be reinforced. The back gate voltage may be equal to the unselect voltage. Alternatively, the back gate voltage may be different to the unselect voltage. For instance, the back gate voltage may be greater than or equal to the unselect voltage. For instance, the back gate voltage may be 7V.

A lower voltage may be applied to the unselect word lines 124_2 and 124_3 compared to a Comparative Example (e.g., without application of the back gate voltage) during the read operation on the select memory cell MC. For example, during the read operation on the select memory cell MC, the unselect voltage VRD applied to the unselect word lines 124_2 and 124_3 may be less than or equal to a predetermined ratio of the threshold voltages associated with a plurality of memory cells. The predetermined ratio may be from 1 to 1.25. That is, the unselect voltage VRD may be less than or equal to 1 to 1.25 times a threshold voltage of the plurality of memory cells. For instance, the unselect voltage VRD may be less than or equal to 1 to 1.25 times a highest threshold voltage (High Vt) of the plurality of memory cells. Specifically, the unselect voltage VRD may be 1.25 times or less of the threshold voltage (High Vt) of the memory cell having the highest threshold voltage (for example, when High Vt is 4V, the unselect voltage VRD may be 5V or less).

Table 1 below shows examples of experimental results for the magnitude of the read current during the read operation according to Comparative Examples and an Example of the present disclosure. In each of the Comparative Examples, and in the Example of the present disclosure, the highest threshold voltage High Vt is 4V.

**[Table 1]**

| Category | [Comparative Example 1] | [Comparative Example 2] | Example |
|---|---|---|---|
| V_{RD} = 7V | 1132nA | 1040nA | - |
| V_{RD} = 5V | 0.112nA | 0.065nA | 1501nA |

Comparative Example 1 shows an example of the read current during the read operation in a semiconductor memory device that does not include the back gate electrode 138, Comparative Example 2 shows an example of the read current during the read operation in a semiconductor memory device that includes the back gate electrode 138, when the back gate voltage VBG is not applied to the back gate electrode 138, and Example shows an example of the read current in a semiconductor memory device including the back gate electrode 138, when the back gate voltage VBG is applied to the back gate electrode 138 during the read operation. According to the experimental results of Table 1, it can be seen that the magnitude of the read current is significantly reduced as the unselect voltage VRD applied to the unselect word lines 124_2 and 124_3 is decreased from 7V to 5V (Table 1 shows 1132nA -> 0.112nA for Comparative Example 1 and 1040nA -> 0.065nA for Comparative Example 2). That is, according to the Comparative Examples, when a relatively low unselect voltage (VRD = 5V in Table 1) is applied, the information stored in the select memory cell MC may not be properly detected. On the other hand, according to the Example, a relatively low unselect voltage (VRD = 5V in Table 1) was applied to the unselect word lines 124_2 and 124_3), but it can be seen that the read current was reinforced by the back gate voltage VBG, so that the magnitude of the read current (1501nA in Table 1) was not decreased compared to when a relatively high unselect voltage (VRD = 7V in Table 1) is applied in the Comparative Examples.

As described above, even if a relatively low voltage is applied to the unselect word lines 124_2 and 124_3, the read current may be reinforced by the back gate voltage VBG and the information stored in the select memory cell MC may be properly detected. It is possible that the read current is insufficient particularly when the number of the stacks of memory devices increases and the channel length increases according to the high-capacity trend, but according to an aspect of the present disclosure, even if the channel length increases, the read current may be reinforced by the back gate voltage VBG and the information stored in the select memory cell MC may be properly detected.

During the read operation, a lower voltage may be applied to the unselect word lines 124_2 and 124_3 compared to the Comparative Example, thereby alleviating the read disturb phenomenon. Accordingly, reliability of the semiconductor memory device may be improved.

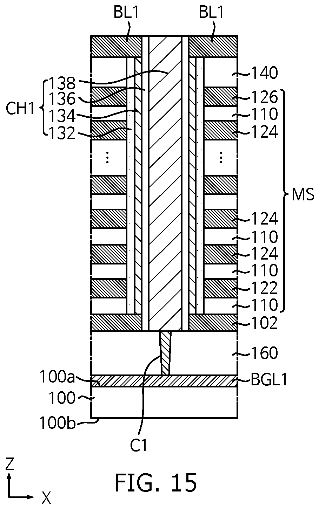

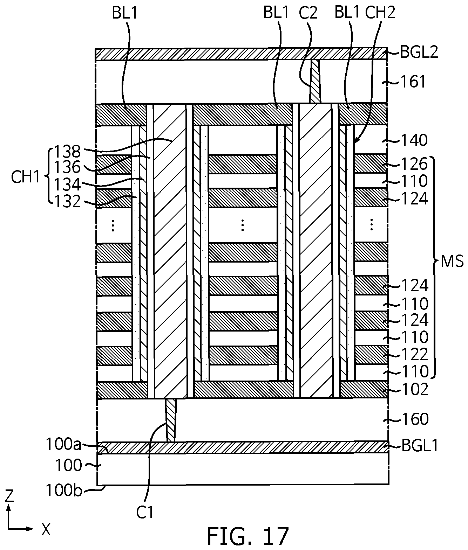

FIGS. 15, 16, and 17 are cross-sectional views illustrating examples of the semiconductor memory device. In the following description of FIGS. 15 to 17, description of the components or operations already described above with reference to FIGS. 1 to 14 will be omitted, and those newly added will be mainly described below with reference to FIGS. 15 FIGS 17.

The semiconductor memory device may further include contacts C1 and/or C2 electrically connected to the back gate electrode 138 and back gate lines BGL1 and/or BGL2 electrically connected to the back gate electrode 138 through the contacts C1 and/or C2.

Referring to FIG. 15, the back gate line BGL1 may be disposed between the cell substrate 100 and the mold structure MS. In this case, the contact C1 may be in contact with a lower portion of the back gate electrode 138, thereby connecting the back gate electrode 138 and the back gate line BGL1. For example, the back gate line BGL1 may be disposed on the first side 100a of the cell substrate 100, and an interlayer insulating layer 160 may be disposed between the back gate line BGL1 and the mold structure MS. The contact C1 may extend through the interlayer insulating layer 160 to connect the back gate electrode 138 and the back gate line BGL1 of the first channel structure CH1.

FIG. 15 illustrates that the uppermost end of the back gate electrode 138 is positioned above the uppermost end of the mold structure MS, but aspects are not limited thereto. For example, in an aspect in which the back gate line BGL1 is disposed between the cell substrate 100 and the mold structure MS, the uppermost end of the back gate electrode 138 may be positioned below the uppermost end of the mold structure MS.

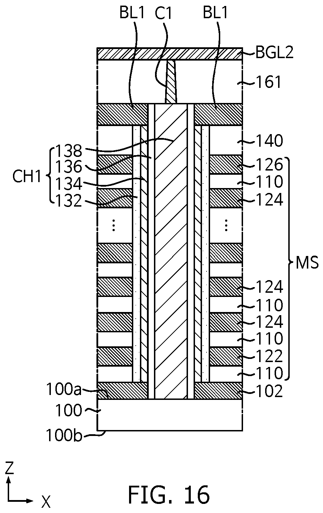

Referring to FIG. 16, the back gate line BGL2 may be disposed on the mold structure MS. In this case, the contact C1 may be in contact with an upper portion of the back gate electrode 138, thereby connecting the back gate electrode 138 and the back gate line BGL2. For example, an interlayer insulating layer 161 may be disposed on the mold structure MS, and the back gate line BGL2 may be disposed on the interlayer insulating layer 161. The contact C1 may extend through the interlayer insulating layer 161 to connect the back gate electrode 138 and the back gate line BGL2 of the first channel structure CH1.

FIG. 16 illustrates that the lowermost end of the back gate electrode 138 is positioned on the same plane as the lowermost end of the mold structure (MS), but aspect are not limited thereto. For example, in an aspect in which the back gate line BGL2 is disposed on the mold structure MS, the lowermost end of the back gate electrode 138 may be positioned above the lowermost end of the mold structure MS.

Referring to FIG. 17, the first back gate line BGL1 may be disposed between the cell substrate 100 and the mold structure MS, and the second back gate line BGL2 may be disposed on the mold structure MS. In this case, the first contact C1 may be in contact with the lower portion of the back gate electrode 138 of the first channel structure CH1, thereby connecting the back gate electrode 138 and the first back gate line BGL1 of the first channel structure CH1. In addition, the second contact C2 may be contact with the upper portion of the back gate electrode of the second channel structure CH2, thereby connecting the back gate electrode and the second back gate line BGL2 of the second channel structure CH2.

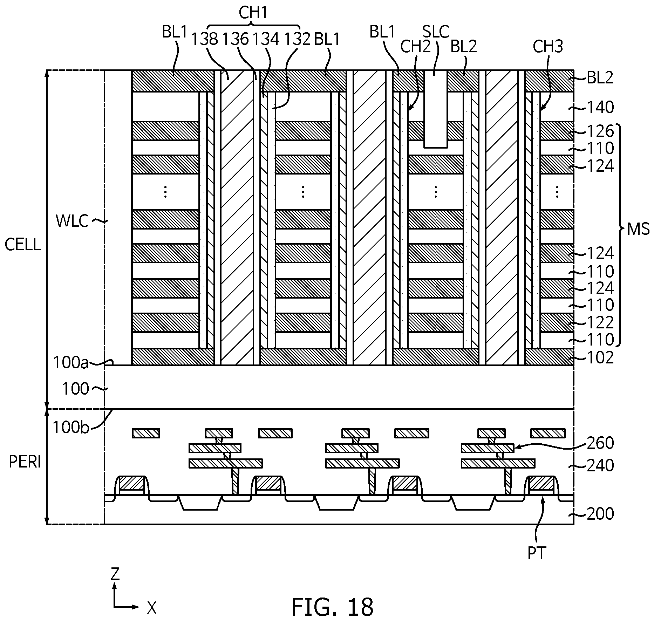

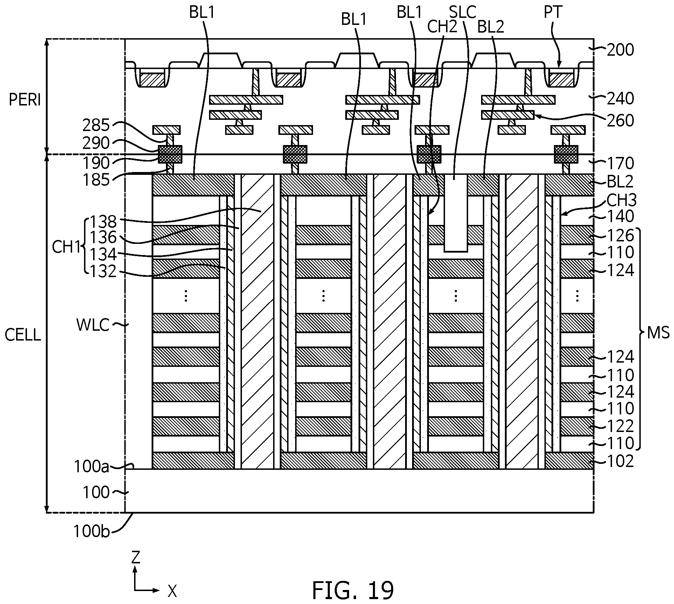

FIGS. 18 and 19 are cross-sectional views illustrating examples of the semiconductor memory device. In the following description of FIGS. 18 and 19, description of the components or operations already described above with reference to FIGS. 1 to 17 will be omitted, and those newly added will be mainly described below with reference to FIGS. 18 and 19.

Referring to FIGS. 18 and 19, a semiconductor memory device may include a cell structure CELL and a peripheral circuit structure PERI.

The cell structure CELL may include the cell substrate 100, the source layer 102, the mold structure MS, the interlayer insulating layer 140, the bit lines BL1 and BL2, the word line cutting structure WLC, the string line cutting structure SLC, the channel structures CH1 to CH8, and the dummy channel structure DCH described above with reference to FIGS. 1 to 17. The cell structure CELL may be stacked on the peripheral circuit structure PERI.

The peripheral circuit structure PERI may include a peripheral circuit substrate 200 (e.g. a peripheral circuit board 200), a peripheral circuit element PT, and a peripheral circuit wiring structure 260.

For example, the peripheral circuit board 200 may include a semiconductor substrate such as a silicon substrate, a germanium substrate, or a silicon-germanium substrate. Alternatively, the peripheral circuit board 200 may also include a silicon-on-insulator (SOI) substrate, a germanium-on-insulator (GOI) substrate, etc.

The peripheral circuit element PT may be disposed on the peripheral circuit board 200. The peripheral circuit element PT may form a peripheral circuit (e.g., 30 in FIG. 1) that controls the operation of the semiconductor memory device. For example, the peripheral circuit element PT may include a control logic (e.g., 37 in FIG. 1), a row decoder (e.g., 33 in FIG. 1), a page buffer (e.g., 35 in FIG. 1), etc. The peripheral circuit element PT may control a voltage applied during the read operation of the semiconductor memory device. For example, during the read operation of a select memory cell, the page buffer (e.g., 35 in FIG. 1) of the peripheral circuit element PT may apply the back gate voltage to the back gate electrode of the channel structure associated with the select memory cell.

The peripheral circuit may comprise a plurality of peripheral circuit elements PT, each connected to a respective back gate electrode of a respective channel structure. The peripheral circuit may be configured to apply a back gate voltage to each channel structure that is connected to a select memory cell during a read operation, and to not apply a back gate voltage (e.g. to disconnect, or apply a ground voltage) to each channel structure that is not connected to a select memory cell (e.g. that is connected only to unselect memory cells).

In the following description, the side of the peripheral circuit board 200, on which the peripheral circuit element PT is disposed, may be referred to as a front side of the peripheral circuit board 200. An opposite side to the front side of the peripheral circuit board 200 may be referred to as a back side of the peripheral circuit board 200.

For example, the peripheral circuit element PT may include a transistor, but is not limited thereto. For example, the peripheral circuit element PT may include not only various active elements such as transistors, but also various passive elements such as capacitors, registers, and inductors.

The peripheral circuit wiring structure 260 may be formed on the peripheral circuit element PT. For example, an inter-wire insulating film 240 may be formed on the front side of the peripheral circuit board 200, and the peripheral circuit wiring structure 260 may be formed in the inter-wire insulating film 240. The peripheral circuit wiring structure 260 may be electrically connected to the peripheral circuit element PT. The number, arrangement, etc. of the layers of the peripheral circuit wiring structure 260 illustrated herein are merely examples, and aspects are not limited thereto.

Referring to FIG. 18, the peripheral circuit structure PERI may be disposed on the second side 100b of the cell substrate 100. The cell structure CELL may be disposed on the inter-wire insulating film 240 of the peripheral circuit structure PERI. For example, the cell wiring structure of the cell structure CELL may be disposed on the mold structure MS, and the cell wiring structure and the peripheral circuit wiring structure 260 may be electrically connected by a through plug extending through the mold structure MS and the cell substrate 100.

Referring to FIG. 19, the peripheral circuit structure PERI may be disposed on the first side 100a of the cell substrate 100. The peripheral circuit structure PERI may be disposed on an interlayer insulating layer 170 of the cell structure CELL.

A first bonding metal 190 may be disposed on the uppermost metal layer of the cell structure CELL. A second bonding metal 290 may be disposed on the uppermost metal layer of the peripheral circuit structure PERI.

The first bonding metal 190 and the second bonding metal 290 may be bonded to each other. As a result, the cell structure CELL and the peripheral circuit structure PERI may be bonded to each other. If the first bonding metal 190 and the second bonding metal 290 include copper (Cu), the bonding method may be a Cu-Cu bonding method, but is not limited thereto.

The first bonding metal 190 may be connected to the bit line BL through a first bonding contact 185. The second bonding metal 290 may be connected to the peripheral circuit elements PT through a second bonding contact 285. Accordingly, the peripheral circuit structure PERI and the cell structure CELL may be electrically connected to each other.

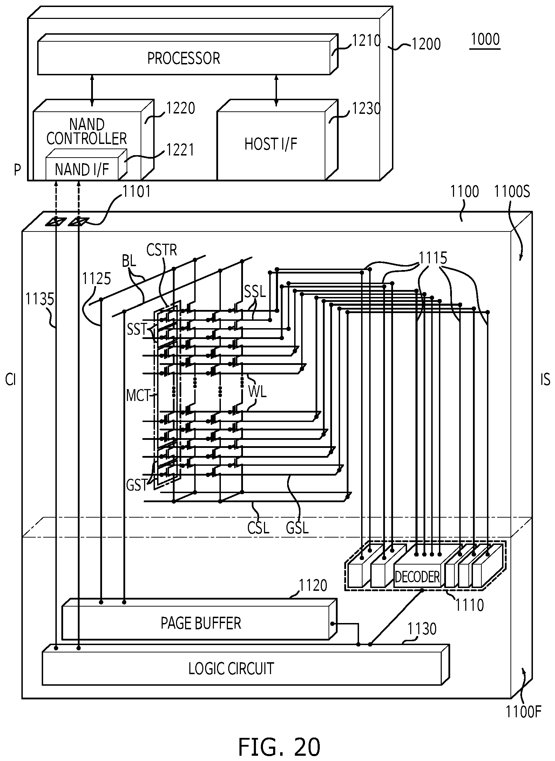

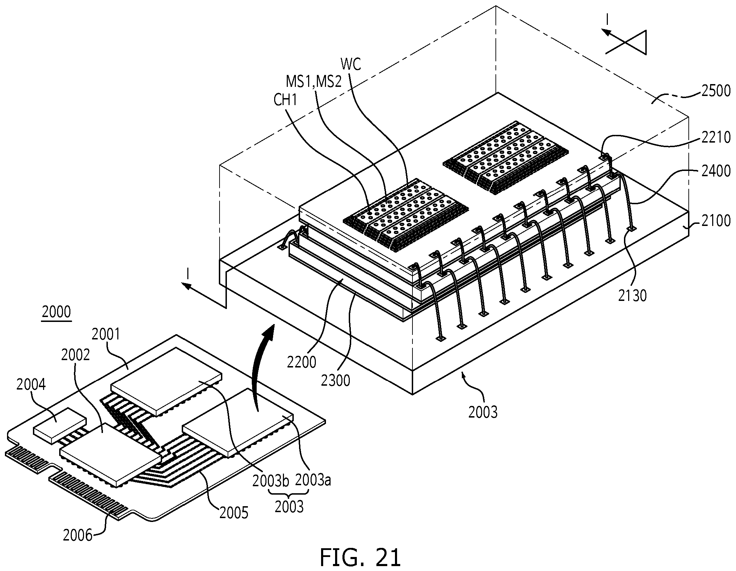

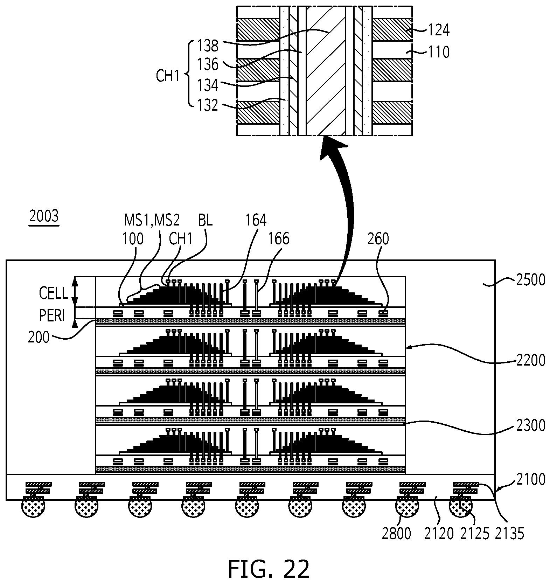

FIG. 20 is a block diagram illustrating an example of an electronic system 1000. FIG. 21 is a perspective view illustrating an example of an electronic system 2000. FIG. 22 is an example cross-sectional view taken along line I-I of FIG. 21. FIGS. 21 and 22 illustrate the first channel structure CH1 as an example.

Referring to FIG. 20, the electronic system 1000 may include a semiconductor memory device 1100 and a controller 1200 electrically connected to the semiconductor memory device 1100. The electronic system 1000 may be a storage device including one or a plurality of semiconductor memory devices 1100 or an electronic device including the storage device. For example, the electronic system 1000 may be a solid state drive device (SSD), a universal serial bus (USB), a computing system, a medical device, or a communication device including one or more semiconductor memory devices 1100.

The semiconductor memory device 1100 may be a non-volatile memory device (e.g., a NAND flash memory device), and for example, may be the semiconductor memory device described above with reference to FIGS. 1 to 19. The semiconductor memory device 1100 may include a first structure 1100F and a second structure 1100S on the first structure 1100F.

The first structure 1100F may be a peripheral circuit structure including a decoder circuit 1110 (e.g., the row decoder 33 of FIG. 1), a page buffer 1120 (e.g., the page buffer 35 of FIG. 1), and a logic circuit 1130 (e.g., the control logic 37 of FIG. 1). For example, the first structure 1100F may correspond to the peripheral circuit structure PERI described above with reference to FIGS. 18 and 19.

The second structure 1100S may include the common source line CSL, the plurality of bit lines BL, and the plurality of cell strings CSTR described above with reference to FIG. 2. The cell string CSTR may be connected to the decoder circuit 1110 through word lines WL, at least one string select line SSL, and at least one ground select line GSL. In addition, the cell string CSTR may be connected to the page buffer 1120 through bit lines BL. For example, the second structure 1100S may correspond to the cell structure CELL described above with reference to FIGS. 1 to 19.

The common source line CSL and the cell string CSTR may be electrically connected to the decoder circuit 1110 through first connection wires 1115 extending from the first structure 1100F to the second structure 1100S.

The bit line BL may be electrically connected to the page buffer 1120 through second connection wires 1125.

The semiconductor memory device 1100 may communicate with the controller 1200 through an input and output pad 1101 electrically connected to the logic circuit 1130 (for example, the control logic 37 of FIG. 1). The input and output pad 1101 may be electrically connected to the logic circuit 1130 through an input and output connection wiring 1135 extending from within the first structure 1100F and to the second structure 1100S.

The controller 1200 may include a processor 1210, a NAND controller 1220, and a host interface 1230. The electronic system 1000 may include the plurality of semiconductor memory devices 1100, and in this case, the controller 1200 may control the plurality of semiconductor memory devices 1100.

The processor 1210 may control the overall operation of the electronic system 1000 including the controller 1200. The processor 1210 may operate according to predetermined firmware, and may control the NAND controller 1220 to access the semiconductor memory device 1100. The NAND controller 1220 may include a NAND interface 1221 that processes communication with the semiconductor memory device 1100. A control command for controlling the semiconductor memory device 1100, data to be written in the memory cell transistors MCT of the semiconductor memory device 1100, data to be read from the memory cell transistors MCT of the semiconductor memory device 1100, etc. may be transmitted through the NAND interface 1221. The host interface 1230 may provide a function of communication between the electronic system 1000 and an external host. Upon receiving a control command from the external host through the host interface 1230, the processor 1210 may control the semiconductor memory device 1100 in response to the control command.

Referring to FIGS. 21 and 22, the electronic system 2000 may include a main substrate 2001, a main controller 2002 mounted on the main substrate 2001, one or more semiconductor packages 2003, and DRAM 2004. The semiconductor package 2003 and the DRAM 2004 may be connected to the main controller 2002 by wiring patterns 2005 formed on the main substrate 2001.

The main substrate 2001 may include a connector 2006 including a plurality of pins coupled to the external host. The number and arrangement of the plurality of pins in the connector 2006 may vary according to a communication interface between the electronic system 2000 and the external host. The electronic system 2000 may communicate with an external host according to any one of interfaces such as Universal Serial Bus (USB), Peripheral Component Interconnect Express (PCI-Express), Serial Advanced Technology Attachment (SATA), and M-Phy for Universal Flash Storage (UFS). The electronic system 2000 may operate by the power supplied from an external host through the connector 2006. The electronic system 2000 may further include a Power Management Integrated Circuit (PMIC) that distributes the power supplied from the external host to the main controller 2002 and the semiconductor package 2003.

The main controller 2002 may record data in the semiconductor package 2003 or read data from the semiconductor package 2003, and may improve the operation speed of the electronic system 2000.

The DRAM 2004 may be a buffer memory to alleviate the speed difference between the external host and the semiconductor package 2003 that is a data storage space. The DRAM 2004 included in the electronic system 2000 may also operate as a kind of cache memory, and may also provide a space for temporarily storing data in a control operation for the semiconductor package 2003. If the electronic system 2000 includes the DRAM 2004, in addition to the NAND controller for controlling the semiconductor package 2003, the main controller 2002 may further include a DRAM controller for controlling the DRAM 2004.

The semiconductor package 2003 may include first and second semiconductor packages 2003a and 2003b spaced apart from each other. Each of the first and second semiconductor packages 2003a and 2003b may be a semiconductor package including a plurality of semiconductor chips 2200. Each of the first and second semiconductor packages 2003a and 2003b may include a package substrate 2100, semiconductor chips 2200 on the package substrate 2100, adhesive layers 2300 disposed on a lower surface of each of the semiconductor chips 2200, a connection structure 2400 electrically connecting the semiconductor chips 2200 and the package substrate 2100, and a molding layer 2500 covering the semiconductor chips 2200 and the connection structure 2400 on the package substrate 2100.

The package substrate 2100 may be a printed circuit board including package upper pads 2130. Each of the semiconductor chips 2200 may include an input and output pad 2210. The input and output pad 2210 may correspond to the input and output pad 1101 of FIG. 20.

The connection structure 2400 may be a bonding wire electrically connecting the input and output pad 2210 to the package upper pads 2130. Therefore, in each of the first and second semiconductor packages 2003a and 2003b, the semiconductor chips 2200 may be electrically connected to each other with the bonding wire method, and may be electrically connected to the package upper pads 2130 of the package substrate 2100. In each of the first and second semiconductor packages 2003a and 2003b, the semiconductor chips 2200 may be electrically connected to each other through a connection structure including through-electrodes (Through Silicon Via, TSV) instead of the bonding wire type connection structure 2400.

The main controller 2002 and the semiconductor chips 2200 may be included in one package. The main controller 2002 and the semiconductor chips 2200 may be mounted on a separate interposer substrate different from the main substrate 2001, and the main controller 2002 and the semiconductor chips 2200 may be connected to each other through wiring formed on the interposer substrate.

The package substrate 2100 may be a printed circuit board. The package substrate 2100 may include a package substrate body portion 2120, the package upper pads 2130 disposed on the upper surface of the package substrate body portion 2120, lower pads 2125 disposed on the lower surface of the package substrate body portion 2120 or exposed through the lower surface, and internal wires 2135 electrically connecting the upper pads 2130 and the lower pads 2125 inside the package substrate body portion 2120. The upper pads 2130 may be electrically connected to the connection structures 2400. The lower pads 2125 may be connected to the wiring patterns 2005 of the main substrate 2001 of the electronic system 2000 through conductive connection portions 2800, as illustrated in FIG. 22.

In the electronic system 2000, each of the semiconductor chips 2200 may include the semiconductor memory device described above with reference to FIGS. 1 to 19. For example, each of the semiconductor chips 2200 may include the peripheral circuit structure PERI and the cell structure CELL stacked on the peripheral circuit structure PERI. For example, the peripheral circuit structure PERI may include the peripheral circuit board 200 and the peripheral circuit wiring structure 260 described above with reference to FIGS. 18 and 19. In addition, for example, the cell structure CELL may include the cell substrate 100, the mold structures MS1 and MS2, the channel structures CH1 to CH8, and the bit line BL described above with reference to FIGS. 5 to 17. In addition, the channel structures CH1 to CH8 may include the ferroelectric layer 132, the channel layer 134, the first insulating layer 136, and the back gate electrode 138, and the back gate voltage may be applied to the back gate electrode 138 during the read operation.

While this specification contains many specific implementation details, these should not be construed as limitations on the scope of any invention or on the scope of what may be claimed, but rather as descriptions of features that may be specific to particular implementations of particular inventions. Certain features that are described in this specification in the context of separate implementations can also be implemented in combination in a single implementation. Conversely, various features that are described in the context of a single implementation can also be implemented in multiple implementations separately or in any suitable subcombination. Moreover, although features may be described above as acting in certain combinations, one or more features from a combination can in some cases be excised from the combination, and the combination may be directed to a subcombination or variation of a subcombination.

Certain examples of the present disclosure have been described above for purposes of illustration only, and those skilled in the art with ordinary knowledge of the present disclosure will be able to make various modifications, changes and additions within the scope of the present disclosure, and such modifications, changes and additions should be construed to be included in a scope of the claims.

It should be understood that those of ordinary skill in the art to which the present disclosure pertains can make various substitutions, modifications and changes without departing from the technical scope of the present disclosure, and thus, the present disclosure is not limited by the aspects described above and the accompanying drawings.

Embodiments are set out in the following Clauses:
Clause 1. A semiconductor memory device, comprising:
   a cell substrate including a first side and a second side, the second side being opposite to the first side;
   a mold structure including a plurality of gate electrodes and a plurality of mold insulating films, the plurality of gate electrodes and the plurality of mold insulating films being alternately stacked on the first side of the cell substrate; and
   a channel structure extending through the mold structure and including a ferroelectric layer, a channel layer, and a back gate electrode, the ferroelectric layer, the channel layer, and the back gate electrode being stacked in turn on a side surface of the plurality of gate electrodes,
   wherein the plurality of gate electrodes and the channel structure define a plurality of memory cells, and
   wherein a back gate voltage is applied to the back gate electrode of the channel structure during a read operation of a select memory cell of the plurality of memory cells.
Clause 2. The semiconductor memory device according to Clause 1, wherein
   the plurality of gate electrodes include a plurality of word lines, and
   during the read operation of the select memory cell, an unselect voltage is applied to an unselect word line of the plurality of word lines, the unselect word line being associated with an unselect memory cell of the plurality of memory cells.
Clause 3. The semiconductor memory device according to Clause 2, wherein the unselect voltage is less than or equal to a predetermined ratio of a threshold voltage associated with the plurality of memory cells.
Clause 4. The semiconductor memory device according to Clause 3, wherein the predetermined ratio is from 1 to 1.25.
Clause 5. The semiconductor memory device according to any of Clauses 2-4, wherein the unselect voltage is greater than or equal to a threshold voltage associated with the plurality of memory cells.
Clause 6. The semiconductor memory device according to any preceding Clause, wherein the channel structure further includes a first insulating layer disposed between the back gate electrode and the channel layer.
Clause 7. The semiconductor memory device according to Clause 6, wherein the channel structure further includes a second insulating layer disposed between the channel layer and the ferroelectric layer.
Clause 8. The semiconductor memory device according to Clause 7, wherein the channel structure further includes a third insulating layer disposed between the plurality of gate electrodes and the ferroelectric layer.
Clause 9. The semiconductor memory device according to any preceding Clause, wherein
   the plurality of gate electrodes include a plurality of word lines,
   during the read operation of the select memory cell, a select voltage is applied to a select word line of the plurality of word lines, the select word line being associated with the select memory cell, and
   the select voltage includes a voltage between highest and lowest threshold voltages of threshold voltages associated with the plurality of memory cells.
Clause 10. The semiconductor memory device according to any preceding Clause, further comprising:
   a contact electrically connected to the back gate electrode; and
   a back gate line electrically connected to the back gate electrode through the contact.
Clause 11. The semiconductor memory device according to Clause 10, wherein the back gate line is disposed between the cell substrate and the mold structure.
Clause 12. The semiconductor memory device according to Clause 11, wherein an uppermost end of the back gate electrode is positioned below an uppermost end of the mold structure.
Clause 13. The semiconductor memory device according to Clause 10, wherein the back gate line is disposed on the mold structure.
Clause 14. The semiconductor memory device according to Clause 13, wherein a lowermost end of the back gate electrode is positioned above a lowermost end of the mold structure.
Clause 15. The semiconductor memory device according to any preceding Clause, further comprising a bit line disposed on the channel structure,
   wherein the bit line is electrically connected to the channel layer, and
   wherein, during the read operation of the select memory cell, a bit line voltage is applied to the bit line.
Clause 16. The semiconductor memory device according to any preceding Clause, further comprising:
   a peripheral circuit board;
   a peripheral circuit element disposed on the peripheral circuit board and configured to apply the back gate voltage to the back gate electrode of the channel structure during the read operation of the select memory cell; and
   a peripheral circuit wiring structure disposed on the peripheral circuit board and electrically connected to the peripheral circuit element,
   wherein the peripheral circuit wiring structure is disposed on the second side of the cell substrate.
Clause 17. The semiconductor memory device according to any of Clauses 1-15, further comprising:
   a peripheral circuit board;
   a peripheral circuit element disposed on the peripheral circuit board and configured to apply the back gate voltage to the back gate electrode of the channel structure during the read operation of the select memory cell; and
   a peripheral circuit wiring structure disposed on the peripheral circuit board and electrically connected to the peripheral circuit element,
   wherein the peripheral circuit wiring structure is disposed on the first side of the cell substrate.
Clause 18. A semiconductor memory device, comprising:
   a cell substrate,
   a mold structure including a plurality of gate electrodes stacked on the cell substrate; and
   a channel structure extending through the mold structure,
   wherein the channel structure includes a ferroelectric layer, a channel layer, and a back gate electrode, and
   wherein, during a read operation, a back gate voltage is applied to the back gate electrode of the channel structure.
Clause 19. An electronic system, comprising:
   a main substrate;
   a semiconductor memory device on the main substrate; and
   a controller electrically connected to the semiconductor memory device on the main substrate,
   wherein the semiconductor memory device includes:
      a cell substrate;
      a mold structure including a plurality of gate electrodes and a plurality of mold insulating films, the plurality of gate electrodes and the plurality of mold insulating films being alternately stacked on the cell substrate; and
      a channel structure extending through the mold structure and including a ferroelectric layer, a channel layer, and a back gate electrode, the ferroelectric layer, the channel layer, and the back gate electrode being stacked in turn on a side surface of the plurality of gate electrodes,
      wherein the plurality of gate electrodes and the channel structure define a plurality of memory cells, and
      wherein a back gate voltage is applied to the back gate electrode of the channel structure during a read operation of a select memory cell of the plurality of memory cells.
Clause 20. The electronic system according to Clause 19, wherein
   the plurality of gate electrodes include a plurality of word lines,
   during the read operation of the select memory cell, an unselect voltage is applied to an unselect word line of the plurality of word lines, the unselect word line being associated with an unselect memory cell of the plurality of memory cells, and
   the unselect voltage is greater than or equal to a threshold voltage associated with the plurality of memory cells.

## Claims

1. A semiconductor memory device, comprising:
a cell substrate including a first side and a second side, the second side being opposite to the first side;
a mold structure including a plurality of gate electrodes and a plurality of mold insulating films, the plurality of gate electrodes and the plurality of mold insulating films being alternately stacked on the first side of the cell substrate; and
a channel structure extending through the mold structure and including a ferroelectric layer, a channel layer, and a back gate electrode, the ferroelectric layer, the channel layer, and the back gate electrode being stacked in turn on a side surface of the plurality of gate electrodes,
wherein the plurality of gate electrodes and the channel structure define a plurality of memory cells, and
wherein a back gate voltage is applied to the back gate electrode of the channel structure during a read operation of a select memory cell of the plurality of memory cells.

2. The semiconductor memory device according to claim 1, wherein
the plurality of gate electrodes include a plurality of word lines, and
during the read operation of the select memory cell, an unselect voltage is applied to an unselect word line of the plurality of word lines, the unselect word line being associated with an unselect memory cell of the plurality of memory cells.

3. The semiconductor memory device according to claim 2, wherein the unselect voltage is less than or equal to a predetermined ratio of a threshold voltage associated with the plurality of memory cells.

4. The semiconductor memory device according to claim 3, wherein the predetermined ratio is from 1 to 1.25.

5. The semiconductor memory device according to any of claims 2-4, wherein the unselect voltage is greater than or equal to a threshold voltage associated with the plurality of memory cells.

6. The semiconductor memory device according to any preceding claim, wherein the channel structure further includes a first insulating layer disposed between the back gate electrode and the channel layer.

7. The semiconductor memory device according to claim 6, wherein the channel structure further includes a second insulating layer disposed between the channel layer and the ferroelectric layer.

8. The semiconductor memory device according to claim 7, wherein the channel structure further includes a third insulating layer disposed between the plurality of gate electrodes and the ferroelectric layer.

9. The semiconductor memory device according to any preceding claim, wherein
the plurality of gate electrodes include a plurality of word lines,
during the read operation of the select memory cell, a select voltage is applied to a select word line of the plurality of word lines, the select word line being associated with the select memory cell, and
the select voltage includes a voltage between highest and lowest threshold voltages of threshold voltages associated with the plurality of memory cells.

10. The semiconductor memory device according to any preceding claim, further comprising:
a contact electrically connected to the back gate electrode; and
a back gate line electrically connected to the back gate electrode through the contact.

11. The semiconductor memory device according to claim 10, wherein the back gate line is disposed between the cell substrate and the mold structure.

12. The semiconductor memory device according to claim 11, wherein an uppermost end of the back gate electrode is positioned below an uppermost end of the mold structure.

13. The semiconductor memory device according to claim 10, wherein the back gate line is disposed on the mold structure.

14. The semiconductor memory device according to claim 13, wherein a lowermost end of the back gate electrode is positioned above a lowermost end of the mold structure.

15. The semiconductor memory device according to any preceding claim, further comprising a bit line disposed on the channel structure,
wherein the bit line is electrically connected to the channel layer, and
wherein, during the read operation of the select memory cell, a bit line voltage is applied to the bit line.
